# EUROPEAN PATENT SPECIFICATION

(11) **EP 1 114 791 B1**
(45) Date of publication and mention of the grant of the patent: **02.05.2007**
(21) Application number: 01300023.7
(22) Date of filing: 03.01.2001
(51) Int. Cl.: B81C 1/00, H01J 9/02

(54) **Method of forming structure having surface roughness due to nano-sized surface features**
Verfahren zur Herstellung einer Struktur mit nanometrischen Oberflächenaufrauhungen
Procédé de formation d'une structure ayant une rugosité de surface causée par des aspérités de taille nanométrique

(30) Priority: 05.01.2000 KR 2000000363
(43) Date of publication of application: 11.07.2001
(73) Proprietor: Samsung SDI Co. Ltd., Suwon-city, Kyonggi-do (KR)
(72) Inventor: Cha, Seung-nam, Seocho-gu, Seoul (KR); Lee, Hang-woo, Paldal-gu, Suwon-city, Kyungki-do (KR); Choi, Jun-hee, Suwon-city, Kyungki-do (KR)
(74) Representative: Kyle, Diana

(56) References cited:
- US-A- 4 642 163
- YUE KUO: "FACTORS AFFECTING THE MOLYBDENUM LINE SLOPE BY REACTIVE LON ETCHING" JOURNAL OF THE ELECTROCHEMICAL SOCIETY, ELECTROCHEMICAL SOCIETY. MANCHESTER, NEW HAMPSHIRE, US, vol. 137, no. 6, 1 June 1990 (1990-06-01), pages 1907-1911, XP000132637 ISSN: 0013-4651

## Description

The present invention relates to a method of forming a micro structure having nano-sized surface features.

Forming a micro structure requires precise fabrication technologies since the micro structure includes a plurality of miniaturized electronic components. Generally, a thin film is grown and formed on one substrate and physicochemically cut in a predetermined pattern at a specific step to obtain a micro structure having a desired structure as disclosed for example in J. of the Electrochemical Society, Vol. 137, no 6, June 1990, page, 1907-1911. In some cases, a micro structure is formed by growing and forming thin films on two substrates, cutting them in predetermined patterns, and combining the two substrates into one.

Typically, a patterning process such as photolithography or plasma etching is applied to form a regularly-structured micro structure. Sometimes a micro structure having an irregular shape with a nano- or micro-sized features may be required. However, since conventional etching techniques are chiefly applied to regularly-shaped micro structure, it is difficult to obtain an micro structure having an irregular shape with a nano- or micro-sized features.

For example, it is known that a micro tip having more edges, which is an electron emission source of a field emission display, is advantageous in electron emission over that a micro chip having a single electron emission edge, but effective fabrication techniques therefor has been not yet proposed.

Micro structures other than the micro tip may also require a structure having an irregular shape of a micro scale or a nano scale.

To solve the above problems, it is an objective of the present invention to provide a method of forming a micro structure having surface roughness due to nano-sized surface features.

According to one aspect of the present invention, there is provided a method of forming a micro structure having nano-sized surface features, the method comprising the steps of:
forming a micro structure having a predetermined size and shape on a substrate;
then coating a carbon polymer layer of a predetermined thickness on the substrate including the micro structure;
performing an etch on the carbon polymer layer by means of plasma etching using a reactive gas in which O₂ gas for etching the carbon polymer layer and a gas for etching the micro structure are mixed, to develop a finely rough surface having nano-sized features on the carbon polymer layer, thereby forming a mask layer on the surface of the micro structure;
and continuing said etching of the carbon polymer layer until the surface of the micro structure is etched, thereby forming said micro structure having nano-sized surface features.

Preferably, the carbon polymer layer is formed of polyimide or photoresist, and etched using reactive ion etching (RIE).

When etching the carbon polymer layer, the reactive gas is preferably composed of O₂ as a main component and at least one of fluorine-family gases such as CF₄, SF₆, and CHF₃ or composed of O₂ as a main component and at least one of chlorine-family gases such as Cl₂ and CCI₄. In particular, if the reactive gas contains fluorine-family gas, at least one of CF₄/O₂, SF₆/O₂, CHF₃/O₂, CF₄/SF₆/O₂, CF₄/CHF₃/O₂, and SF₆/CHF₃/O₂ is preferably applied. If the reactive gas contains chlorine-family gas, at least one of CI₂/O₂, CCI₄/O₂, and CI₂/CCI₄/O₂ is applied.

In etching the micro structure, an etch rate is preferably adjusted by at least one of plasma power, the O₂ content of the reactive gas with respect to the etch gas for etching the micro structure and a plasma process pressure, thereby controlling the surface roughness of the micro structure.

The above objective and advantages of the present invention will become more apparent by describing in detail a preferred embodiment thereof with reference to the attached drawings in which:
FIG. 1 shows a state in which a target layer is formed on a substrate according to a method of forming a micro structure under the present invention;
FIG. 2 shows a state in which a mask layer is formed on the target layer according to the method of forming a micro structure under the present invention;
FIGS. 3A and 3B show states in which the target layer is etched according to the method of forming the micro structure under the present invention, respectively;
FIGS. 4A and 4B show states in which a carbon polymer layer is formed on the target layer according to the method of forming a micro structure under the present invention;
FIGS. 5A and 5B show a state in which the carbon polymer layer on the target layer is etched by an O₂ plasma to form a grass-like structure according to the method of forming a micro structure under the present invention;
FIGS. 6A and 6B show a state in which the carbon polymer layer on the target layer is etched by the O₂ plasma to form the grass-like structure while remaining as a mask for the target layer according to the method of forming a micro structure under the present invention;
FIGS. 7A and 7B show a state in which the target layer has nano-sized surface features when the residual carbon polymer layer acts as a mask according to the method of forming a micro structure under the present invention; and
FIG. 8 is an electron micrograph of the target layer formed according to the method of forming a micro structure under the present invention.

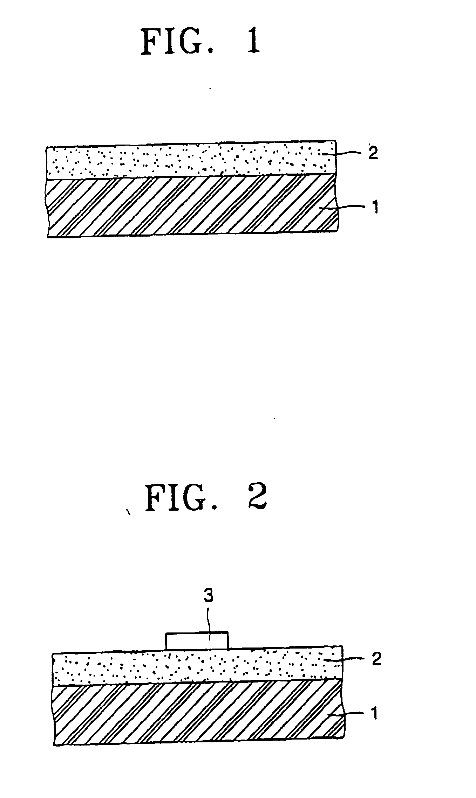

As shown in FIG. 1, a target layer 2 is formed on a substrate 1. Here, the target layer 2 is a portion to be formed as a micro structure according to a method of the present invention and may include one or a mixture of two or more selected among the group consisting of molybdenum (Mo), tungsten (W), silicon, and diamond.

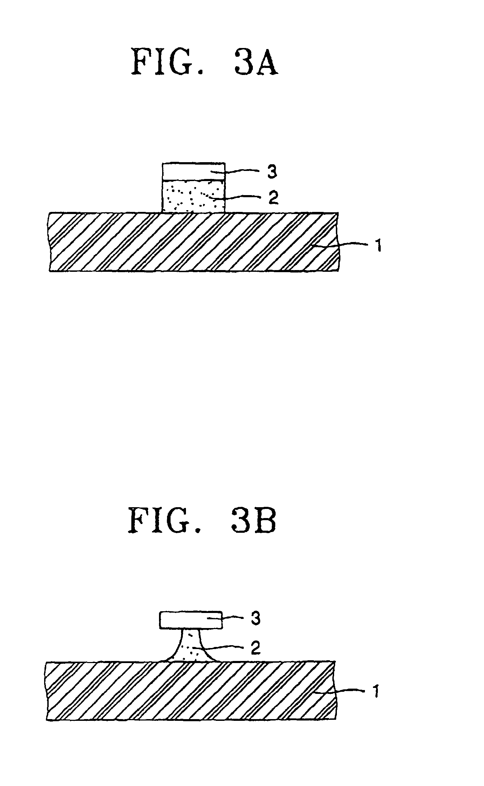

Referring to FIG. 2, a mask layer 3 having a predetermined pattern is formed on top of the target layer 2. As shown in FIGS. 3A - 3B, isotropic or anisotropic etching is performed to remove a portion of the target layer 2 which is not covered by the mask layer 3. Here, FIGS. 3A and 3B show the results of anisotropic and isotropic etching, respectively.

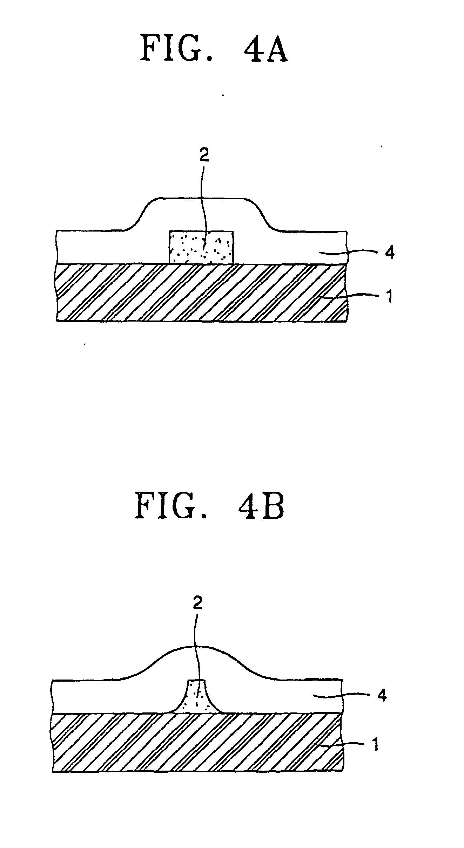

As shown in FIGS. 4A and 4B, following removal of the mask layer 3, a carbon polymer layer 4 is formed on the target layer 2. The carbon polymer layer 4 is formed of photoresist or polyimide by means of a spin coating technique. The carbon polymer layer 4 is formed through processes of spin coating, soft baking and curing while maintaining the thickness thereof in the range of 1 - 20 µm.

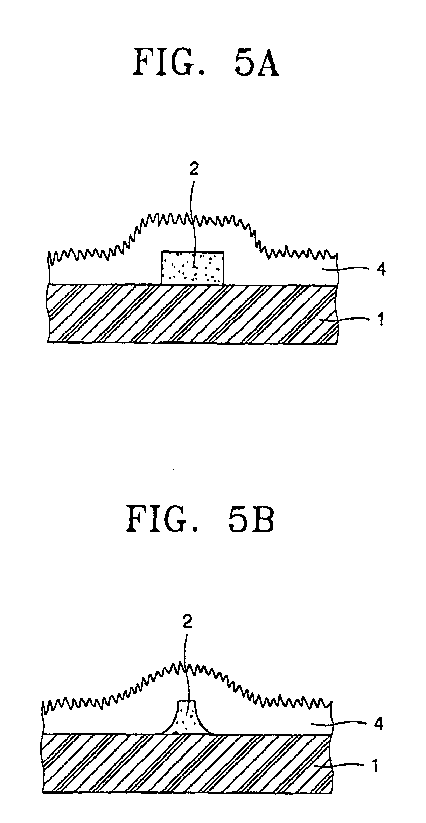

As shown in FIGS. 5A and 5B, dry etching is performed on the carbon polymer layer 4 through plasma etching, in particular, reactive ion etching (RIE). During plasma etching, a reactive gas may be composed of O₂ gas as a main component and fluorine-family gas such as CF₄, CF₆, and CHF₃ For example, the reactive gas may include at least one of CF₄/O₂, SF₆/O₂, CHF₃/O₂, CF₄/SF₆/O₂, CF₄/CHF₃/O₂, and SF₆/CHF₃/O₂. Also, the reactive gas may be a mixture of O₂ gas and chlorine-family gas. In this case, the reactive gas may include at least one of Cl₂/O₂, CCl₄/O₂, and Cl₂/CCl₄/O₂

During dry etching by O₂ plasma, the carbon polymer layer 4 is etched to form a grass-like structure as shown in FIGS. 5A and 5B. The grass-like structure refers to a structure having a finely rough etching surface due to variations in local etch rate. In this case, O₂ is added to fluorine- or chlorine- family gas so as to increase the etch rate of polyimide, that is, to facilitate etching of a top end of the target layer 2 when a micro tip of the target layer 2 is exposed to plasma as the carbon polymer layer 4 is etched. Here, in etching the carbon polymer layer 4, the etch rate of the target layer 2 by plasma is adjusted depending on the mol ratio of O₂ to fluorine- or chlorine-family gas, a process pressure, plasma power, and the like. Since the carbon polymer layer 4 is etched to form a grass-structure in this way, carbon polymer remains on a portion of the surface of the target layer 2 thereby acting as a mask for the target layer 2.

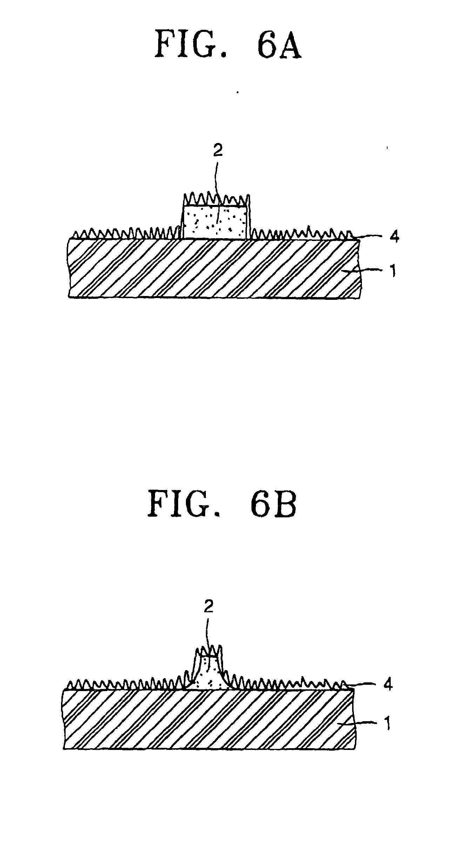

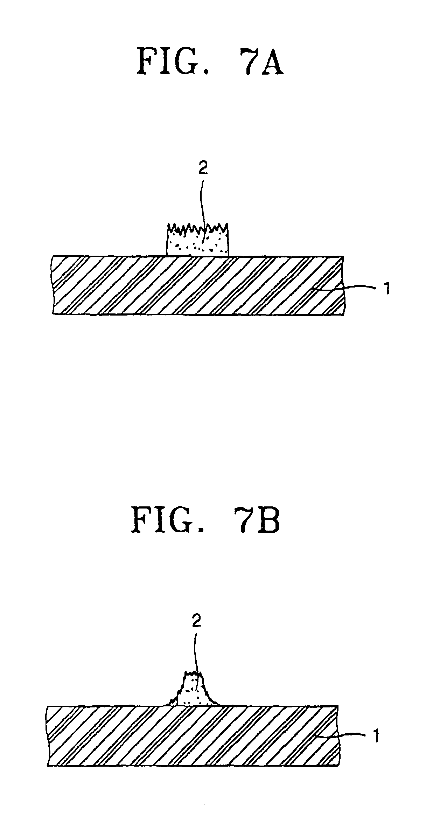

If the carbon polymer layer 4 continues to be etched as shown in FIGS. 6A and 6B, the carbon polymer layer 4 is almost removed and the target layer 2 begins to be etched. Finally, the target layer 2 originally having a flat surface has nano-sized surface features as shown in FIGS. 7A and 7B.

The surface roughness of the micro structure are adjusted depending on the difference in etch rate between the micro structure and the carbon polymer layer 4. In particular, the etch rate is preferably controlled by adjusting at least one of plasma power, the O₂ content of the reactive gas with respect to the etch gas for etching the micro structure, or a plasma process pressure.

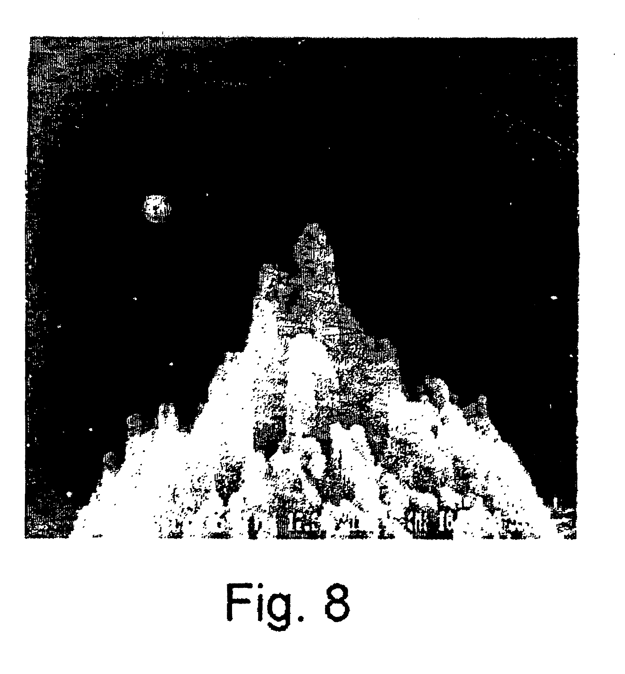

FIG. 8 is an electron micrograph showing the structure of the target layer 2 of FIG. 7B having nano-sized surface features formed on the substrate 1, which is subjected to the above process.

The method of forming a micro structure having nano-sized surface features as described above is suitable for formation of an electron emission source such as a field emission display. Furthermore, any other micro structure having nano-sized surface features can be manufactured easily by the method.

For example, according to a test conducted by the inventor of this invention, in the case of a FED device manufactured by the method of forming a micro structure as described above, a gate turn on voltage and a working voltage are reduced by about 20 V and 40 - 50 V, respectively, compared to a conventional FED having the same structure. Here, a working voltage refers to a voltage at which emission current of 0.3mA is obtained at duty ratio of 1/90 and frequency of 60 Hz.

As described above, the height and surface roughness of the micro tip can be adjusted by appropriately controlling an etch rate or etch speed between the micro tip and the carbon polymer layer according to plasma process conditions. The etch rate is adjusted by controlling at least of one of plasma power, the O₂ content of the reactive gas with respect to the etch gas for etching the micro structure, and a plasma process pressure.

The present invention can easily give nano-sized surface features to the surface of a regularly structured micro structure. The method of forming a micro structure according to the present invention may be included in a process of forming another micro structure having a desired function. The present invention can also be applied to any structure other than FED, which requires the structure as described above.

Although this invention has been particularly shown and described with references to preferred embodiments thereof, the illustrated embodiments are only examples.

## Claims

1. A method of forming a micro structure having nano-sized surface features, the method comprising the steps of:
forming a micro structure (2) having a predetermined size and shape on a substrate (1);
then coating a carbon polymer layer (4) of a predetermined thickness on the substrate (1) including the micro structure;
performing an etch on the carbon polymer layer (4) by means of plasma etching using a reactive gas in which O₂ gas for etching the carbon polymer layer and a gas for etching the micro structure are mixed, to develop a finely rough surface having nano-sized features on the carbon polymer layer (4), thereby forming a mask layer (3) on the surface of the micro structure (2); and
continuing said etching of the carbon polymer layer (4) until the surface of the micro structure is etched, thereby forming said micro structure (2) having nano-sized surface features.

2. The method of claim 1, wherein the carbon polymer layer (4) is formed of polyimide or photoresist.

3. The method of claim 1 or 2, wherein the carbon polymer layer (4) is etched using reactive ion etching (RIE).

4. The method of claim 3, wherein the surface roughness of the micro structure (2) is controlled by adjusting the difference in etch rate between the micro structure (2) and the carbon polymer layer (4).

5. The method of claim 4, wherein the etch rate is adjusted by at least one of plasma power, the O₂ content of the reactive gas with respect to the etch gas for etching the micro structure (2) and a plasma process pressure.

6. The method of claim 3, wherein the micro structure is formed of one or a mixture of two or more selected from molybdenum (Mo), tungsten (W), silicon, and diamond, and the reactive gas is a mixture of O₂ gas and fluorine-family gas.

7. The method of claim 6, wherein the reactive gas comprises at least one of CF₄/O₂, SF₆/O₂, CHF₃/O₂, CF₄/SF₆/O₂, CF₄/CHF₃/O₂, and SF₆/CHF₃/O₂.

8. The method of claim 3, wherein the micro structure is formed of one or a mixture of two or more selected from molybdenum (Mo), tungsten (W), silicon, and diamond, and the reactive gas is a mixture of O₂ gas and chlorine-family gas.

9. The method of claim 8, wherein the reactive gas comprises at least one of CI₂/O₂, CCI₄/O₂, and CI₂/CCI₄/O₂.

## Patentansprüche

1. Verfahren zum Ausbilden einer Mikrostruktur mit Oberflächenstrukturen in Nanogröße, wobei das Verfahren die Schritte umfasst:
Ausbilden einer Mikrostruktur (2) in einer bestimmten Größe und Form auf einem Substrat (1);
dann Auftragen einer Kohlenstoffpolymerschicht (4) in einer bestimmten Dicke auf das Substrat (1) mit der Mikrostruktur;
Durchführen einer Ätzung auf der Kohlenstoffpolymerschicht (4) mittels Plasmaätzen unter Verwendung eines Reaktionsgases, in dem O₂-Gas zum Ätzen der Kohlenstoffpolymerschicht und ein Gas zum Ätzen der Mikrostruktur gemischt sind, so dass sich eine feine raue Oberfläche mit Nanostrukturen auf der Kohlenstoffpolymerschicht (4) entwickelt, wodurch eine Maskenschicht (3) auf der Oberfläche der Mikrostruktur (2) gebildet wird; und
Fortsetzen des Ätzens der Kohlenstoffpolymerschicht (4), bis die Oberfläche der Mikrostruktur geätzt ist, wodurch die Mikrostruktur (2) mit Nanooberflächenstrukturen gebildet wird.

2. Verfahren nach Anspruch 1, wobei die Kohlenstoffpolymerschicht (4) aus Polyimid oder Photoresist gebildet wird.

3. Verfahren nach Anspruch 1 oder 2, wobei die Kohlenstoffpolymerschicht (4) unter Verwendung von reaktivem Ionenätzen (RIE) geätzt wird.

4. Verfahren nach Anspruch 3, wobei die Oberflächenrauigkeit der Mikrostruktur (2) durch Einstellen der Differenz der Ätzrate zwischen der Mikrostruktur (2) und der Kohlenstoffpolymerschicht (4) beeinflusst wird.

5. Verfahren nach Anspruch 4, wobei die Ätzrate durch Plasmaenergie, O₂-Gehalt des Reaktionsgases in Bezug auf das Ätzgas zum Ätzen der Mikrostruktur (2) und/oder Plasmaprozessdruck eingestellt wird.

6. Verfahren nach Anspruch 3, wobei die Mikrostruktur aus einem oder einer Mischung von zwei oder mehreren ausgewählt aus Molybdän (Mo), Wolfram (W), Silicium und Diamant gebildet wird und das Reaktionsgas eine Mischung von O₂-Gas und Gas aus der Fluorfamilie ist.

7. Verfahren nach Anspruch 6, wobei das Reaktionsgas CF₄/O₂, SF₆/O₂, CHF₃/O₂, CF₄/SF₆/O₂, CF₄/CHF₃/O₂ und/oder SF₆/CHF₃/O₂ umfasst.

8. Verfahren nach Anspruch 3, wobei die Mikrostruktur aus einem oder einer Mischung von zwei oder mehreren ausgewählt aus Molybdän (Mo), Wolfram (W), Silicium und Diamant gebildet wird und das Reaktionsgas eine Mischung von O₂-Gas und Gas aus der Chlorfamilie ist.

9. Verfahren nach Anspruch 8, wobei das Reaktionsgas Cl₂/O₂, CCl₄/O₂ und/oder Cl₂/CCl₄/O₂ umfasst.

## Revendications

1. Procédé de formation d'une microstructure ayant des aspérités de surface de taille nanométrique, le procédé comprenant les étapes consistant à :
former une microstructure (2) ayant une taille et une forme prédéterminées sur un substrat (1) ;
appliquer ensuite une couche de polymère carboné (4) d'une épaisseur prédéterminée sur le substrat (1) englobant la microstructure ;
réaliser une gravure de la couche de polymère carboné (4) par le biais d'une gravure plasma en utilisant un gaz réactif dans lequel le gaz O₂ pour graver la couche de polymère carboné et un gaz pour graver la microstructure sont mélangés, de façon à développer une surface légèrement rugueuse ayant des aspérités de taille nanométrique sur la couche de polymère carboné (4), formant ainsi une couche de masque (3) sur la surface de la microstructure (2) ; et
poursuivre ladite gravure de la couche de polymère carboné (4) jusqu'à ce que la surface de la microstructure soit gravée, formant ainsi ladite microstructure (2) ayant des aspérités de surface de taille nanométrique.

2. Procédé selon la revendication 1, dans lequel la couche de polymère carboné (4) est faite en polyimide ou en résine photosensible.

3. Procédé selon la revendication 1 ou 2, dans lequel la couche de polymère carboné (4) est gravée en utilisant la gravure ionique réactive (RIE).

4. Procédé selon la revendication 3, dans lequel la rugosité de surface de la microstructure (2) est contrôlée en ajustant la différence de vitesse de gravure entre la microstructure (2) et la couche de polymère carboné (4).

5. Procédé selon la revendication 4, dans lequel la vitesse de gravure est ajustée au moins par l'un des paramètres suivants : la puissance plasma, la teneur en O₂ du gaz réactif par rapport au gaz de gravure pour graver la microstructure (2) et la pression du procédé plasma.

6. Procédé selon la revendication 3, dans lequel la microstructure est formée d'un composé ou d'un mélange de deux composés ou plus choisis à partir du molybdène (Mo), du tungstène (W), du silicium et du diamant, et le gaz réactif est un mélange de gaz O₂ et de gaz de la famille du fluor.

7. Procédé selon la revendication 6, dans lequel le gaz réactif comprend au moins l'un des composés suivants : CF₄/O₂, SF₆/O₂, CHF₃/O₂, CF₄/SF₆/O₂, CF₄/CHF₃/O₂ et SF₆/CHF₃/O₂.

8. Procédé selon la revendication 3, dans lequel la microstructure est formée d'un composé ou d'un mélange de deux composés ou plus choisis à partir du molybdène (Mo), du tungstène (W), du silicium et du diamant, et le gaz réactif est un mélange de gaz O₂ et de gaz de la famille du chlore.

9. Procédé selon la revendication 8, dans lequel le gaz réactif comprend au moins l'un des composés suivants : CI₂/O₂, CCI₄/O₂ et CI₂/CCI₄/O₂.
